# EUROPÄISCHE PATENTSCHRIFT

(11) **EP 3 673 507 B1**
(45) Veröffentlichungstag und Bekanntmachung des Hinweises auf die Patenterteilung: **20.09.2023**
(21) Anmeldenummer: 18750330.5
(22) Anmeldetag: 23.07.2018
(51) Int. Cl.: H01M 10/42, H01M 50/107, H01M 50/213, H01M 50/227, H01M 50/244, H01M 50/284, H01M 50/507, H01M 50/517, H01G 2/08, H01G 11/10, H01G 11/18, H05K 7/20

(54) **ENERGIESPEICHERANORDNUNG UND FAHRZEUG MIT ENERGIESPEICHERANORDNUNG**
ENERGY STORAGE ASSEMBLY, AND VEHICLE COMPRISING AN ENERGY STORAGE ASSEMBLY
AGENCEMENT ACCUMULATEUR D'ÉNERGIE ET VÉHICULE POURVU DE L'AGENCEMENT ACCUMULATEUR D'ÉNERGIE

(30) Priorität: 22.08.2017 DE 102017007831
(43) Veröffentlichungstag der Anmeldung: 01.07.2020
(73) Patentinhaber: SEW-EURODRIVE GmbH & Co. KG, 76646 Bruchsal (DE)
(72) Erfinder: SCHMIDT, Josef, 76676 Graben-Neudorf (DE); SCHUMANN, Christian, 76774 Leimersheim (DE); SCHÄFER, Jens, 76676 Graben-Neudorf (DE); ZÖLLER, Thomas, 76646 Bruchsal (DE); HAUCK, Matthias, 68723 Schwetzingen (DE)
(86) Internationale Anmeldenummer: PCT/EP2018/025200
(87) Internationale Veröffentlichungsnummer: WO 2019/037891

(56) Entgegenhaltungen:
- EP-A1- 1 973 023
- US-A1- 2006 164 812
- US-A1- 2010 247 979

## Beschreibung

Die Erfindung betrifft eine Energiespeicheranordnung **und Fahrzeug mit Energiespeicheranordnung.**

Als Energiespeicheranordnung ist ein Akkumulator bekannt.

**Aus der** US 2011 / 0 156 655 A1 **ist eine Energiespeicheranordnung bekannt.**

**Aus der** DE 10 2012 000 996 A1 **ist eine Energiespeicherzellenanordnung bekannt.**

**Aus der** DE 10 2015 119 447 A1 **ist eine Vorrichtung zur Versorgung mit elektrischer Energie aus Akkumulatorzellen bekannt.**

**Aus der** US 2016 / 0 039 266 A1 **ist ein Steuermodul für eine elektrische Anwendung bekannt.**

**Aus der** DE 101 02 671 A1 **ist eine elektrische Heizung für ein Kraftfahrzeug bekannt.**

**Aus der** DE 102 14 448 A1 **ist ein Trennschalter bekannt.**

**Aus der** DE 10 2006 009 812 A1 **ist eine elektrische Schaltung mit mehreren Leistungshalbleitern bekannt.**

**Aus der** DE 11 2015 003 034 T5 **ist ein Schalterkasten bekannt.**

**Aus der** EP 1 973 023 A1 **ist als nächstliegender Stand der Technik ein Stromversorgungspack bekannt.**

**Aus der** US 2010/247979 A1 **ist eine Batteriemodulschnittstelle bekannt.**

**Aus der** US 2006/164812 A1 **ist eine Wärmestrahlstruktur für ein Sekundärbatteriemodul bekannt.**

Der Erfindung liegt daher die Aufgabe zugrunde, eine Energiespeicheranordnung **und Fahrzeug mit Energiespeicheranordnung** weiterzubilden, wobei eine kompakte Ausführung kostengünstig und einfach herstellbar sein soll.

Erfindungsgemäß wird die Aufgabe bei der Energiespeicheranordnung nach den in Anspruch 1 **und bei dem Fahrzeug nach den in Anspruch 12** angegebenen Merkmalen gelöst.

Wichtige Merkmale der Erfindung bei der Energiespeicheranordnung sind, dass die Energiespeicheranordnung
- einen Energiespeicher mit einer ersten Stromschiene, welche ein erstes, insbesondere oberes, Potential führt,
- ein Gehäuseteil, insbesondere Unterteil,
- eine Leiterplatte
- einen erster Montagewinkel
- einen erstes Anschlussblech
- einen ersten steuerbaren Halbleiterschalter, welcher auf der Leiterplatte bestückt ist,

aufweist, wobei die Leiterplatte mit dem ersten Montagewinkel verbunden ist, insbesondere schraubverbunden ist,
wobei der erste Montagewinkel mit dem Gehäuseteil verbunden ist, insbesondere stoffschlüssig, insbesondere als Verbundteil,
wobei die Leiterplatte mit einem ersten Anschlusselement bestückt ist
insbesondere wobei das erste Anschlusselement mit einer ersten Leiterbahn der Leiterplatte elektrisch verbunden ist, insbesondere einpressverbunden ist,
wobei die erste Stromschiene mit dem ersten Anschlusselement verbunden ist, insbesondere schraubverbunden,
wobei ein Anschluss des ersten Halbleiterschalters mit dem ersten Anschlusselement elektrisch verbunden ist und ein anderer Anschluss des ersten Halbleiterschalters mit dem ersten Montagewinkel und dem ersten Anschlussblech elektrisch und thermisch leitend zur Abfuhr von Verlustwärme des ersten Halbleiterschalters verbunden ist, wobei erster Montagewinkel und erstes Anschlussblech miteinander elektrisch und thermisch leitend verbunden sind.

Von Vorteil ist dabei, dass die Verlustwärme des Halbleiterschalters aufgespreizt wird über den Montagewinkel und das Anschlussblech. Denn diese sind mit dem Halbleiterschalter thermisch leitfähig verbunden. Auf diese Weise ist ein zusätzlicher Kühlkörper einsparbar und somit die Energiespeicheranordnung kompakt ausführbar. Hinzu kommt, dass der Montagewinkel im Gehäuseteil verankert ist und die Leiterplatte hält. Somit ist der Montagewinkel einerseits als mechanisches Verbindungsteil verwendbar und andererseits zur Entwärmung des Halbleiterschalters. Zusätzlich ist noch das Anschlussblech thermisch leitfähig verbunden mit dem Montageblech. Auf dieses Weist ist eine noch weiter verbesserte Wärmabfuhr realisierbar. Der überwiegende Teil der Verlustwärme des Halbleiterschalters, insbesondere also weit mehr als 50%, ist über den Montagewinkel und das Anschlussblech an die Umgebung abführbar.

Die erfindungsgemäße Energiespeicheranordnung wird in intralogistischen Fahrzeugen, wie automatisch geführte Fahrzeuge oder in Fahrer-losen Transportsystemen, eingesetzt und/oder in mobilen Assistenzsystemen.

Zur Herstellung kompakter Fahrzeuge, ist eine leistungsfähige Energiespeicheranordnung notwendig. Damit die thermische Belastung von Schaltern und angebundener Leitungen reduziert wird, wäre eine Reduzierung der ohmschen Verluste durch die Erhöhung von Leitungsquerschnitten oder Parallelisierten Ausführungen möglich, was allerdings ein Ansteigen von Bauraum und Kosten bewirkt. Auch eine Verbesserung der Kühlung durch Erhöhung der Oberfläche, Veränderung der Oberfläche, aktive Kühlung und/oder Flüssigkeitskühlung bewirkt eine Erhöhung von Bauraum und Kosten. Erfindungsgemäß wird jedoch eine Reduzierung der maximalen Temperatur der Bauelemente durch eine Erhöhung der Wärmekapazität der Wärmesenke, insbesondere Kühlkörper, bewirkt, wobei die pro Verlustleistung und Zeitdauer erreichte Temperaturerhöhung reduziert wird, ohne dass Bauraum und Kosten erhöht werden.

Bei einer vorteilhaften Ausgestaltung ist der Montagewinkel mit einer Gewindebuchse verbunden, welche in eine ersten Durchkontaktierung der Leiterplatte eingepresst ist,
wobei das erste Anschlussblech einer weiteren Gewindebuchse verbunden ist, welche in eine zweite Durchkontaktierung der Leiterplatte eingepresst ist,
wobei eine Leiterbahn der Leiterplatte die erste mit der zweiten Durchkontaktierung sowie dem anderen Anschluss des Halbleiterschalters elektrisch verbindet,
insbesondere wobei in unterschiedlichen Lagen der mehrlagig ausgeführten Leiterplatten angeordneten Leiterbahnen der Leiterplatte die erste mit der zweiten Durchkontaktierung sowie dem anderen Anschluss des Halbleiterschalters elektrisch verbinden. Von Vorteil ist dabei, dass die Leiterbahnen nicht nur zur Weiterleitung eines elektrischen Potentials oder einen elektrischen Strom, sondern vor allem auch zur Weiterleitung eines Wärmestroms verwendbar sind. Somit wird die Wärmekapazität der Wärmesenke des jeweiligen Halbleiterschalters vergrößert und auftretende Spitzentemperaturen sind absenkbar.

Bei einer vorteilhaften Ausgestaltung liegt die Leiterplatte am Montagewinkel an und ist ausgerichtet,
insbesondere wobei eine Kante der Leiterplatte am Montagewinkel, insbesondere an einem Grundflächenbereich des Montagewinkels anliegt, wobei ein zum Grundflächenbereich gebogen ausgebildeter Laschenbereich an der Leiterplatte anliegt, wobei die mit dem Montagewinkel verbundene Gewindebuchse im Laschenbereich des Montagewinkels angeordnet ist. Von Vorteil ist dabei, dass eine zum Montagewinkel relative Ausrichtung der Leiterplatte in einfacher Weise ermöglicht ist, wobei der Montagewinkel nicht nur zur Vergrößerung der Wärmesenke, sondern auch zum Halten der Leiterplatte verwendbar ist. Somit sind zwei Funktionen mit dem Montagewinkel erreichbar.

Bei einer vorteilhaften Ausgestaltung ist der Grundflächenbereich des Montagewinkels in Richtung einer oder der am Montagewinkel anliegenden Kante der Leiterplatte vor dem Laschenbereich weiter ausgedehnt als der Laschenbereich in Richtung der Kante der Leiterplatte,
wobei der Grundflächenbereich des Montagewinkels in Richtung der Kante der Leiterplatte hinter dem Laschenbereich weiter ausgedehnt ist als der Laschenbereich in Richtung der Kante der Leiterplatte. Von Vorteil ist dabei, dass eine möglichst große Ausführung des Montagewinkels ermöglicht ist.

Bei einer vorteilhaften Ausgestaltung weist
- der Energiespeicher eine zweite Stromschiene auf, welche ein zweites, insbesondere unteres, Potential führt,
- einen zweiter Montagewinkel
- ein zweites Anschlussblech
- einen zweiten steuerbaren Halbleiterschalter, welcher auf der Leiterplatte bestückt ist,

wobei die Leiterplatte mit einem zweiten Anschlusselement bestückt ist,
wobei die Leiterplatte mit dem zweiten Montagewinkel verbunden ist, insbesondere schraubverbunden ist,
wobei der erste Montagewinkel vom zweiten Montagewinkel beabstandet ist,
wobei der zweite Montagewinkel mit dem Gehäuseteil verbunden ist, insbesondere stoffschlüssig,
insbesondere wobei das zweite Anschlusselement mit einer zweiten Leiterbahn der Leiterplatte elektrisch verbunden ist, insbesondere einpressverbunden ist,
wobei die zweite Stromschiene mit dem zweiten Anschlusselement verbunden ist, insbesondere schraubverbunden,
wobei ein Anschluss des zweiten Halbleiterschalters mit dem zweiten Anschlusselement elektrisch über eine Sicherung und/oder einen Shuntwiderstand verbunden ist und ein anderer Anschluss des zweiten Halbleiterschalters mit dem zweiten Montagewinkel und dem zweiten Anschlussblech elektrisch und thermisch leitend zur Abfuhr von Verlustwärme des zweiten Halbleiterschalters verbunden ist, wobei erster Montagewinkel und erstes Anschlussblech miteinander elektrisch und thermisch leitend verbunden sind. Von Vorteil ist dabei, dass auch die Wärme des anderen Halbleiterschalters abführbar ist.

Bei einer vorteilhaften Ausgestaltung ist der erste und/oder der zweite Montagewinkel als Blechteil ausgebildet, insbesondere als Stanz-Biegeteil. Von Vorteil ist dabei, dass eine einfache Herstellung ermöglicht ist.

Bei einer vorteilhaften Ausgestaltung sind das Gehäuseteil, der erste und/oder der zweite Montagewinkel als Verbundteil ausgebildet, insbesondere wobei die beiden Montagewinkel zumindest teilweise umspritzt sind mit Kunststoffmaterial des Gehäuseteils. Von Vorteil ist dabei, dass eine einfache Herstellung und eine hohe Isolationsspannung erreichbar sind.

Bei einer vorteilhaften Ausgestaltung ist das Gehäuseteil aus Kunststoff gefertigt. Von Vorteil ist dabei, dass eine einfache Herstellung als Kunststoffspritzgussteil ausführbar ist.

Bei einer vorteilhaften Ausgestaltung weist das erste Anschlussblech einen hervorragenden ersten Pin auf und/oder weist das zweite Anschlussblech einen hervorragenden zweiten Pin auf. Von Vorteil ist dabei, dass ein einfaches Verbinden einer elektrischen Leitung, wie Kabelstecker oder Steckverbinder, ermöglicht ist.

Bei einer vorteilhaften Ausgestaltung ist der Energiespeicher mit dem ersten Halbleiterschalter, dem zweiten Halbleiterschalter, mit einer Sicherung und/oder mit einem Shunt-Widerstand in Reihe geschaltet. Von Vorteil ist dabei, dass bei Überstrom ein Abschalten zum Schutz des Energiespeichers erfolgt. Außerdem ist der Strom in einfacher Weise als am Shunt-Widerstand abfallende Spannung erfassbar.

Bei einer vorteilhaften Ausgestaltung ist das erste Anschlusselement mit dem ersten Montagewinkel und mit dem ersten Anschlussblech elektrisch und thermisch verbunden. Von Vorteil ist dabei, dass die Wärme des Halbleiterschalters aufspreizbar ist.

Die Erfindung wird nun anhand von schematischen Abbildungen näher erläutert:

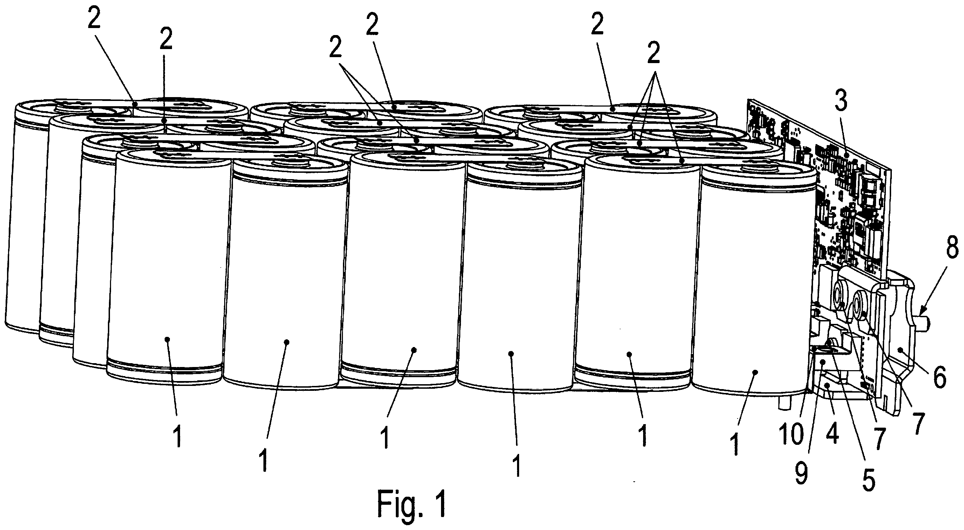

In der Figur 1 ist eine Schrägansicht auf eine Energiespeicheranordnung bei entferntem Gehäuse dargestellt.

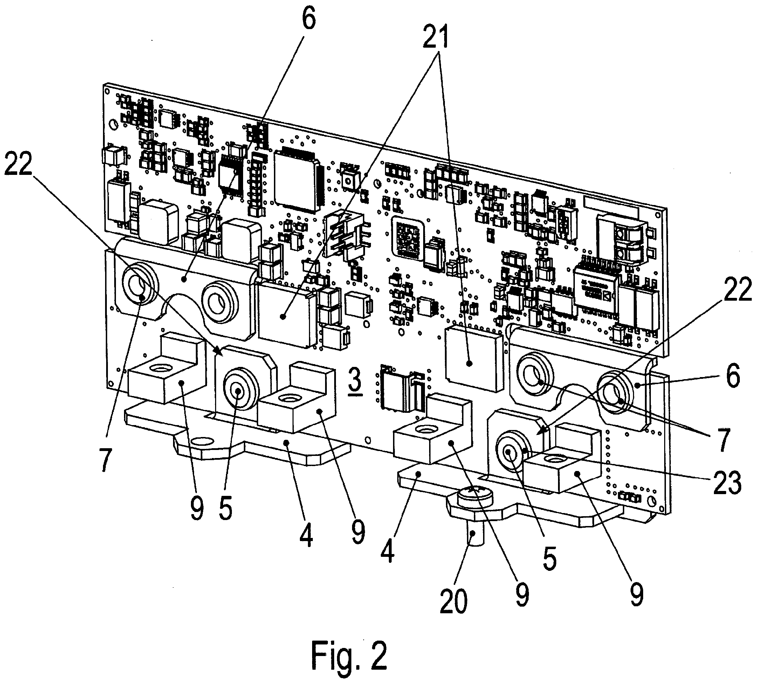

In der Figur 2 ist eine Leiterplatte 3 der Energiespeicheranordnung in Schrägansicht dargestellt.

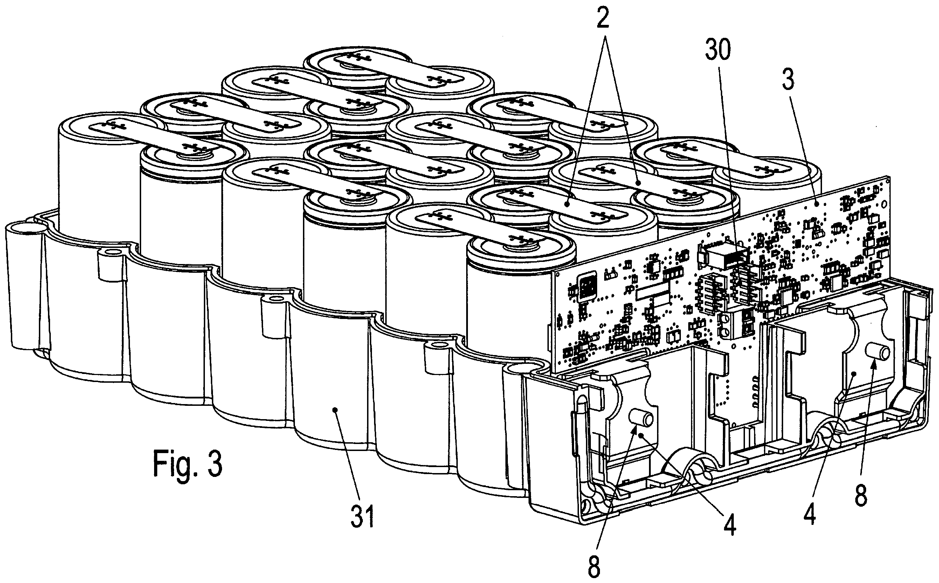

In der Figur 3 ist eine Schrägansicht auf eine Energiespeicheranordnung, wobei das Unterteil 31 des Gehäuses vorhanden ist.
In der Figur 4 ist ein schematischer elektrischer Schaltplan der Energiespeicheranordnung dargestellt.

Wie in den Figuren dargestellt, weist die Energiespeicheranordnung Energiespeicherzellen 1 auf. Die Energiespeicherzellen 1 sind zumindest teilweise in Reihenschaltung zu einem Energiespeicher zusammengeschaltet.

Der Energiespeicher ist in einem Gehäuse angeordnet, welches vorzugsweise aus einem Unterteil 31 und einem darauf aufgesetzten Oberteil zusammengesetzt ist.

Die Energiespeicherzellen 1 weisen eine im Wesentlichen zylindrische Außenform auf. Das Unterteil 31 weist entsprechend geformte Aufnahmebereiche auf. Die Energiespeicherzellen 1 sind parallel zueinander ausgerichtet. Somit sind die Zylinderachsen der Energiespeicherzellen 1 zueinander parallel und die Energiespeicherzellen 1 überdecken jeweils denselben axialen Bereich
Die Zusammmenschaltung der Energiespeicherzellen 1 ist mit Stromschienen 2 ausgeführt und weist zwei elektrische Anschlüsse auf, wobei der erste dieser Anschlüsse ein oberes Potential und der andere der Anschlüsse ein unteres Potential führt.

Jeder der Anschlüsse ist als Stromschiene 10 realisiert, welche als Stanz-Biegeteil ausgeführt ist.

An einem seitlichen Endbereich ist eine Leiterplatte 3 angeordnet, wobei die Leiterplattenebene parallel zu den Zylinderachsen ausgerichtet ist.

Die Leiterplatte 3 ist mit elektronischen Bauelementen bestückt und mit zumindest zwei Anschlussblöcken 9.

Die Stromschiene 10, welche das obere Potential führt, ist mit einem ersten der Anschlussblöcke 9 verbunden. Die andere Stromschiene 10, welche das untere Potential führt, ist mit dem anderen Anschlussblock 9, **also mit einem Anschlusselement,** verbunden.

Auf der Leiterplatte 3 sind auch zumindest zwei steuerbare Halbleiterschalter (T1, T2) bestückt.

Der Energiespeicher ist mit seinem oberen Potential mit dem Source-Anschluss des ersten Halbleiterschalters T1 verbunden. Der Drain-Anschluss des ersten Halbleiterschalters T1 ist mit dem Montagewinkel 4 und Anschlussblech 6 elektrisch und gut wärmeleitend verbunden. Vorzugsweise ist der erste Halbleiterschalter T1 auf der Leiterplatte 3 bestückt.

Somit spreizt sich die vom ersten Halbleiterschalter T1 erzeugte Wärme über das Montagewinkel 4 und das Anschlussblech 6 auf.

Da der erste Montagewinkel 4 mit dem Unterteil 31 verbunden ist, welches aus einem elektrisch isolierenden Material, insbesondere Kunststoff, ausgeführt ist, ist keine weitere Isolationsmaßnahme für den ersten Montagewinkel 4 notwendig. Vorzugsweise ist der erste Montagewinkel 4 im Unterteil 31 umspritzt angeordnet, also das Gehäuse mit dem Montagewinkel 31 als Verbundteil hergestellt.

Der Energiespeicher 43 ist mit seinem unteren Potential mit dem Source-Anschluss des zweiten Halbleiterschalters T2 verbunden, wobei eine Sicherung 41 und ein Shuntwiderstand 42 in Reihe zwischengeordnet ist. Der Drain-Anschluss des zweiten Halbleiterschalters T2 ist mit dem zweiten Montagewinkel 4 und dem zweiten Anschlussblech 6 elektrisch und gut wärmeleitend verbunden.

Somit spreizt sich die vom zweiten Halbleiterschalter T2 erzeugte Wärme über den Montagewinkel 4 und das Anschlussblech 6 auf.

Vorzugsweise ist der zweite Halbleiterschalter T2 auf der Leiterplatte 3 bestückt.

Da der zweite Montagewinkel 4 mit dem Unterteil 31 verbunden ist, welches aus einem elektrisch isolierenden Material, insbesondere Kunststoff, ausgeführt ist, ist keine weitere Isolationsmaßnahme für den zweiten Montagewinkel 4 notwendig. Vorzugsweise ist der zweite Montagewinkel 4 im Unterteil 31 umspritzt angeordnet, also das Gehäuse mit dem zweiten Montagewinkel als Verbundteil hergestellt.

Jedes Anschlussblech 6 weist einen Anschlusspin 8 auf, welche hervorragen, so dass eine einfache Kontaktierung mit einem Steckverbinderteil ermöglicht ist. Das Anschlussblech 6 ist in einer für Stromschienen üblichen Stärke beziehungsweise mit einem entsprechenden Querschnitt ausgeführt, so dass hohe Ströme durchleitbar sind.

Mittels des Montagewinkels 4 ist die Leiterplatte 3 in ihrer Ausrichtung relativ zum Unterteil gehalten. Der Anschlussblock 9, **also das Anschlusselement,** ist auf der dem Energiespeicher zugewandten Seite der Leiterplatte angeordnet..

Auf der vom Energiespeicher abgewandten Seite der Leiterplatte 3 ist ein Steckverbinderteil 30 für Signalleitungen bestückt. Somit ist ein Datenbus mit einer Signalelektronik zum Datenaustausch verbindbar, wobei die Signalelektronik auf der Leiterplatte 3 bestückte elektronische Bauelemente aufweist.

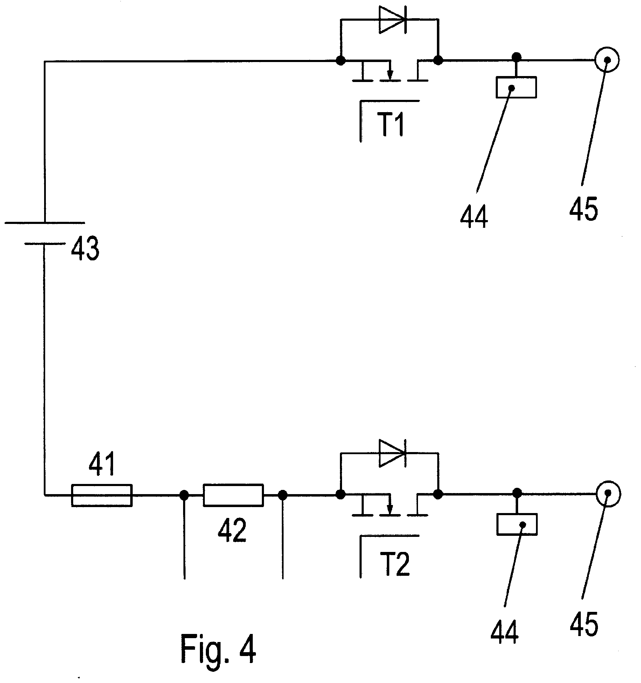

Wie in Figur 4 dargestellt, ist der steuerbare Halbleiterschalter T1 und der steuerbare Halbleiterschalter T2 jeweils als MOSFET ausgeführt.

Mit dem Energiespeicher 43, also der Zusammenschaltung der Energiespeicherzellen 1, ist eine Sicherung 41 und ein Shunt-Widerstand 42 in Reihe geschaltet. Somit ist mittels Erfassung der am Shunt-Widerstand abfallenden Spannung der durch die Reihenschaltung fließende Strom bestimmbar.

Die beiden Halbleiterschalter T1 und T2 sind am oberen beziehungsweise am unteren Anschluss der genannten Reihenschaltung angeordnet und mit ihrem jeweiligen Drain-Anschluss elektrisch mit dem jeweiligen Montageblech 44 und Anschlussblech 45 verbunden.

Jedem der beiden Halbleiterschalter T1 und T2 ist jeweils eine Inversdiode, insbesondere Freilaufdiode, parallel zwischen Drain- und Source-Anschluss des jeweiligen Halbleiterschalters T1 und T2 zugeschaltet.

Somit bewirkt das Öffnen des Halbleiterschalter T1 oder T2 jeweils ein Sperren des Lade- oder Entladevorgangs.

Ein Schließen des Halbleiterschalters T1 bewirkt ein Freigeben des Ladevorgangs. Ein alternativ dazu ausgeführtes Schließen des Halbleiterschalters T2 ein Freigeben des Entladevorgangs.

Die auf der Leiterplatte 3 bestückten Bauteile oder Elemente sind jeweils mit jeweiligen Leiterbahnen der Leiterplatte elektrisch verbunden, vorzugsweise einpressverbunden.

Der Montagewinkel 4 ist als Stanz-Biegeteil gefertigt. Dabei ist ein Laschenbereich 22 aus einem ebenen Grundflächenbereich hochgebogen. Im Laschenbereich 22 ist eine durchgehende Ausnehmung, insbesondere Rundloch, angeordnet, durch welche eine Gewindebuchse 23 hindurchragt, welche eingepresst ist in eine Durchkontaktierung der Leiterplatte 3. Eine Schraube 5 ist von der anderen Seite der Leiterplatte 3 herkommend eingeschraubt in das Innengewinde der Gewindebuchse 23. Auf diese Weise ist eine Schraubverbindung zwischen Montagewinkel 4 und Leiterplatte 3 bewirkbar.

Da die Leiterplatte 3 am Laschenbereich 22 anliegt, ist die Leiterplatte 3 an der ebenen Oberfläche des Laschenbereichs 22 ausgerichtet. Die Ausrichtung des noch verbleibenden Drehfreiheitsgrades der leiterplatte 3 relativ zum Montagewinkel erfolgt an dem Grundflächenbereich des Montagewinkels 4. Eine untere Kante der Leiterplatte 3 liegt an dem ebenen Grundflächenbereich des Montagewinkels 4 an und richtet somit die Leiterplatte 3 zum Montagewinkel 4 aus.

Mittels einer Schraube 20, welche durch eine durchgehende Ausnehmung, insbesondere Rundloch, hindurchragt, wird der Montagewinkel 4 angeschraubt.

Auf der Leiterplatte 3 ist der Halbleiterschalter (21, T1) bestückt, wobei er auf derselben Seite wie der Laschenbereich 22 angeordnet ist.

Das Anschlussblech 6 ist ebenfalls als Stanz-Biegeteil ausgeführt. Das Anschlussblech 6 ragt durch einen nach außen offen ausgeführten Längsschlitz der Leiterplatte und liegt mit einem ebenen Beriech an derselben Seite an der Leiterplatte 3 an wie auch der Laschenbereich 22.

Wiederum ist eine mechanische und elektrische Befestigung mittels einer eingepressten Gewindebuchse 7 erreicht, welche in eine weitere Durchkontaktierung der Leiterplatte eingepresst ist.

Die Leiterplatte 3 ist als Multilayer-Leiterplatte ausgeführt, also mehrlagig ausgeführt. Vorzugsweise verbinden zwei oder mehr Leiterbahnen der leiterplatte 3 die mit der Gewindebuchse 23 in Kontakt stehende Durchkontaktierung elektrisch mit der mit der Gewindebuchse 7 in Kontakt stehenden Durchkontaktierung. Auf diese Weise ist nicht nur eine elektrische, sondern auch eine thermische Anbindung erreicht. Außerdem führen eine oder mehrere der Leiterbahnen auch zu einem Anschluss des Halbleiterschalters (21, T1), so dass dessen Wärme zu den Gewindebuchsen 7 und 23 hin aufspreizbar ist, also dann auch zum Montagewinkel 4 und zum Anschlussblech 6 hin.

Die Wärmekapazität des Montagewinkels 4 ist außerdem sehr groß, indem der Montagewinkel 4 entlang der Kante der am Montagewinkel 4 anliegenden Leiterplatte 3 vor und hinter dem Laschenbereich 23 verbreitert ausgeführt ist. Vorzugsweise ist der vor dem Laschenbereich 23 anliegende Bereich entlang der Kante länger als der Laschenbereich in Kantenrichtung. Ebenso ist der hinter dem Laschenbereich 23 anliegende Bereich entlang der Kante länger als der Laschenbereich in Kantenrichtung.

Bei weiteren erfindungsgemäßen Ausführungsbeispielen ist die Zusammenschaltung der Energiespeicherzellen 1 als zwei gleiche Untereinheiten ausgeführt ist, so weist jede dieser Untereinheiten zwei Stromschienen 1. Die auf der Leiterplatte 3 benötigte Anzahl der Anschlussblöcke 9 erhöht sich dann auf vier, wobei zwei elektrisch miteinander verbundene Anschlussblöcke 9 das obere elektrische Potential der ersten Untereinheit mit dem unteren elektrischen Potential der zweiten Untereinheit verbinden, also in Reihe schalten. Durch die Verwendung zweier Untereinheiten sind die Handhabung und die Fertigung des Energiespeichers 43 vereinfacht. Zudem wird ein Zwischenpotential des Energiespeichers 43 für Überwachungszwecke auf der Leiterplatte 3 verfügbar gemacht

Bei weiteren erfindungsgemäßen Ausführungsbeispielen werden die Energiespeicherzellen 1 parallelgeschaltet oder es werden parallel geschaltete Gruppen von in Reihe geschalteten Energiespeicherzellen 1 gebildet.

Bei weiteren erfindungsgemäßen Ausführungsbeispielen sind anstatt der in Figur 4 dargestellten steuerbaren Halbleiterschaltern T1 und steuerbaren Halbleiterschaltern T2 jeweils Parallelschaltungen von mehreren Halbleiterschaltern realisierbar. Bei einer Parallelschaltung von zwei Halbleiterschaltern pro Schalter T1 und T2 kann der jeweils zweite Halbleiterschalter direkt auf der gegenüberliegenden Leiterplattenseite platziert werden. Bei Ausführung von entsprechenden Durchkontaktierungen profitiert auch dieser jeweils zweite Halbleiterschalter von der guten thermischen Anbindung des jeweils ersten Halbleiterschalters.

### Bezugszeichenliste

1 Energiespeicherzelle
2 Stromschiene
3 Leiterplatte
4 Montagewinkel
5 Schraube
6 Anschlussblech
7 Einpressgewindebuchse
8 Anschlusspin
9 Anschlusselement
10 Stromschiene
20 Schraube
21 Halbleiterschalter
22 Laschenbereich, hochgebogen
23 Gewindebuchse
30 Steckverbinderteil für Signalleitungen
31 Unterteil
41 Sicherung
42 Shunt-Widerstand
43 Energiespeicher, insbesondere Zusammenschaltung der Energiespeicherzellen 1
44 Anschluss für Montagewinkel
45 Anschluss für Anschlussblech 6

## Patentansprüche

1. Energiespeicheranordnung,
aufweisend
- einen Energiespeicher (43) mit einer ersten Stromschiene (2), welche ein erstes, insbesondere oberes, Potential führt,
- ein Gehäuseteil, insbesondere Unterteil (31),
- eine Leiterplatte (3)
- einen ersten Montagewinkel (4)
- ein erstes Anschlussblech (6)
- einen ersten steuerbaren Halbleiterschalter (21, T1), welcher auf der Leiterplatte (3) bestückt ist,
**dadurch gekennzeichnet, dass**
die Leiterplatte (3) mit dem ersten Montagewinkel (4) verbunden ist, insbesondere schraubverbunden ist,
wobei der erste Montagewinkel (4) mit dem Gehäuseteil verbunden ist, insbesondere stoffschlüssig, insbesondere als Verbundteil,
wobei die Leiterplatte (3) mit einem ersten Anschlusselement (9) bestückt ist
insbesondere wobei das erste Anschlusselement (9) mit einer ersten Leiterbahn der Leiterplatte (3) elektrisch verbunden ist, insbesondere einpressverbunden ist,
wobei die erste Stromschiene (2) mit dem ersten Anschlusselement (9) verbunden ist, insbesondere schraubverbunden,
wobei ein Anschluss des ersten Halbleiterschalters (21, T1) mit dem ersten Anschlusselement (9) elektrisch verbunden ist und ein anderer Anschluss des ersten Halbleiterschalters (21, T1) mit dem ersten Montagewinkel (4) und dem ersten Anschlussblech (6) elektrisch und thermisch leitend zur Abfuhr von Verlustwärme des ersten Halbleiterschalters (21, T1) verbunden ist, wobei erster Montagewinkel (4) und erstes Anschlussblech (6) miteinander elektrisch und thermisch leitend verbunden sind.

2. Energiespeicheranordnung nach Anspruch 1,
**dadurch gekennzeichnet, dass**
der Montagewinkel (4) mit einer Gewindebuchse (23) verbunden ist, welche in eine ersten Durchkontaktierung der Leiterplatte (3) eingepresst ist,
wobei das erste Anschlussblech (6) einer weiteren Gewindebuchse (23) verbunden ist, welche in eine zweite Durchkontaktierung der Leiterplatte (3) eingepresst ist,
wobei eine Leiterbahn der Leiterplatte (3) die erste mit der zweiten Durchkontaktierung sowie dem anderen Anschluss des Halbleiterschalters (21, T1) elektrisch verbindet,
insbesondere wobei in unterschiedlichen Lagen der mehrlagig ausgeführten Leiterplatte (3) angeordnete Leiterbahnen der Leiterplatte (3) die erste mit der zweiten Durchkontaktierung sowie dem anderen Anschluss des Halbleiterschalters (21, T1) elektrisch verbinden.

3. Energiespeicheranordnung nach Anspruch 1 oder 2,
**dadurch gekennzeichnet, dass**
die Leiterplatte (3) am Montagewinkel (4) anliegt und ausgerichtet ist,
**wobei** eine Kante der Leiterplatte (3) am Montagewinkel (4), insbesondere an einem Grundflächenbereich des Montagewinkels (4) anliegt, wobei ein zum Grundflächenbereich gebogen ausgebildeter Laschenbereich (22) an der Leiterplatte (3) anliegt, wobei die mit dem Montagewinkel (4) verbundene Gewindebuchse (23) im Laschenbereich (22) des Montagewinkels (4) angeordnet ist.

4. Energiespeicheranordnung nach Anspruch 3,
**dadurch gekennzeichnet, dass**
der Grundflächenbereich des Montagewinkels (4) in Richtung **der** am Montagewinkel (4) anliegenden Kante der Leiterplatte (3) vor dem Laschenbereich (22) weiter ausgedehnt ist als der Laschenbereich (22) in Richtung der Kante der Leiterplatte (3),
wobei der Grundflächenbereich des Montagewinkels (4) in Richtung der Kante der Leiterplatte (3) hinter dem Laschenbereich (22) weiter ausgedehnt ist als der Laschenbereich (22) in Richtung der Kante der Leiterplatte (3).

5. Energiespeicheranordnung nach einem der vorhergehenden Ansprüche,
**dadurch gekennzeichnet, dass**
- der Energiespeicher (43) eine zweite Stromschiene (10) aufweist, welche ein zweites, insbesondere unteres, Potential führt,
- ein zweiter Montagewinkel
- ein zweites Anschlussblech
- ein zweiter steuerbarer Halbleiterschalter, welcher auf der Leiterplatte (3) bestückt ist,
wobei die Leiterplatte (3) mit einem zweiten Anschlusselement bestückt ist,
wobei die Leiterplatte (3) mit dem zweiten Montagewinkel verbunden ist, insbesondere schraubverbunden ist,
wobei der erste Montagewinkel (4) vom zweiten Montagewinkel beabstandet ist,
wobei der zweite Montagewinkel mit dem Gehäuseteil verbunden ist, insbesondere stoffschlüssig,
insbesondere wobei das zweite Anschlusselement mit einer zweiten Leiterbahn der Leiterplatte (3) elektrisch verbunden ist, insbesondere einpressverbunden ist,
wobei die zweite Stromschiene (10) mit dem zweiten Anschlusselement verbunden ist, insbesondere schraubverbunden,
wobei ein Anschluss des zweiten Halbleiterschalters mit dem zweiten Anschlusselement elektrisch über eine Sicherung (41) und/oder einen Shuntwiderstand verbunden ist und ein anderer Anschluss des zweiten Halbleiterschalters mit dem zweiten Montagewinkel und dem zweiten Anschlussblech elektrisch und thermisch leitend zur Abfuhr von Verlustwärme des zweiten Halbleiterschalters verbunden ist, wobei erster Montagewinkel (4) und erstes Anschlussblech (6) miteinander elektrisch und thermisch leitend verbunden sind.

6. Energiespeicheranordnung nach einem der vorhergehenden Ansprüche,
**dadurch gekennzeichnet, dass**
der erste und/oder der zweite Montagewinkel (4) als Blechteil ausgebildet ist, insbesondere als Stanz-Biegeteil.

7. Energiespeicheranordnung nach einem der vorhergehenden Ansprüche,
**dadurch gekennzeichnet, dass**
das Gehäuseteil, der erste und/oder der zweite Montagewinkel (4) als Verbundteil ausgebildet ist oder sind, insbesondere wobei die beiden Montagewinkel (4) zumindest teilweise umspritzt sind mit Kunststoffmaterial des Gehäuseteils.

8. Energiespeicheranordnung nach Anspruch 5,
**dadurch gekennzeichnet, dass**
die steuerbaren Halbleiterschalter **(21, T1, T2)** jeweils als Parallelschaltung mehrerer Halbleiterschalter ausgeführt sind,
insbesondere wobei jede der Parallelschaltungen jeweils einen ersten und einen zweiten Halbleiterschalter aufweist, wobei bei jeder der Parallelschaltungen der jeweils zweite Halbleiterschalter direkt auf der zum jeweils ersten Halbleiterschalter (21, T1) gegenüberliegenden Leiterplattenseite platziert ist und mittels einer oder mehreren Durchkontaktierungen dieser jeweils zweite Halbleiterschalter wärmeleitend verbunden ist mit dem jeweils ersten Halbleiterschalter (21, T1).

9. Energiespeicheranordnung nach einem der vorhergehenden Ansprüche,
**dadurch gekennzeichnet, dass**
das Gehäuseteil aus Kunststoff gefertigt ist.

10. Energiespeicheranordnung nach einem der vorhergehenden Ansprüche,
**dadurch gekennzeichnet, dass**
das erste Anschlussblech (6) einen hervorragenden ersten Pin aufweist
und/oder dass
das zweite Anschlussblech einen hervorragenden zweiten Pin aufweist.

11. Energiespeicheranordnung nach einem der Ansprüche 5 oder 8,
**dadurch gekennzeichnet, dass**
der Energiespeicher (43) mit dem ersten Halbleiterschalter (21, T1), dem zweiten Halbleiterschalter, mit einer Sicherung (41) und/oder mit einem Shunt-Widerstand (42) in Reihe geschaltet sind.

12. Fahrzeug mit Energiespeicheranordnung nach einem der vorhergehenden Ansprüche, **dadurch gekennzeichnet, dass**
das Fahrzeug ein Transportmittel einer intralogistischen Anlage ist,
insbesondere wobei das Transportmittel ein automatisch geführtes Fahrzeug oder ein Fahrer-loses Transportsystem oder ein mobiles Assistenzsystem.

## Claims

1. Energy storage arrangement comprising:
- an energy storage device (43) having a first busbar (2) that conducts a first, in particular upper, potential,
- a housing part, in particular a bottom part (31),
- a printed circuit board (3),
- a first assembly bracket (4),
- a first connection sheet (6),
- a first controllable semiconductor switch (21, T1) that is fitted on the printed circuit board (3),
**characterised in that**
the printed circuit board (3) is connected, in particular screw-connected, to the first assembly bracket (4),
wherein the first assembly bracket (4) is connected to the housing part, in particular in an integrally bonded manner, in particular as a composite part,
wherein the printed circuit board (3) is fitted with a first connection element (9),
in particular wherein the first connection element (9) is electrically connected, in particular press-fitted, to a first conducting track of the printed circuit board (3),
wherein the first busbar (2) is connected, in particular screw-connected, to the first connection element (9),
wherein a terminal of the first semiconductor switch (21, T1) is electrically connected to the first connection element (9), and another terminal of the first semiconductor switch (21, T1) is connected to the first assembly bracket (4) and the first connection sheet (6) in an electrically and thermally conductive manner in order to carry away thermal losses of the first semiconductor switch (21, T1), wherein the first assembly bracket (4) and the first connection sheet (6) are interconnected in an electrically and thermally conductive manner.

2. Energy storage arrangement according to claim 1,
**characterised in that**
the assembly bracket (4) is connected to a threaded bush (23) that is pressed into a first via of the printed circuit board (3),
wherein the first connection sheet (6) is connected to a further threaded bush (23) that is pressed into a second via of the printed circuit board (3),
wherein a conducting track of the printed circuit board (3) electrically connects the first via to the second via and to the other terminal of the semiconductor switch (21, T1),
in particular wherein conducting tracks of the printed circuit board (3), which are arranged in different layers of the multilayer printed circuit board (3), electrically connect the first via to the second via and to the other terminal of the semiconductor switch (21, T1).

3. Energy storage arrangement according to claim 1 or claim 2,
**characterised in that**
the printed circuit board (3) abuts the assembly bracket (4) and is aligned,
wherein an edge of the printed circuit board (3) abuts the assembly bracket (4), in particular abuts a base region of the assembly bracket (4), wherein a lug region (22) formed in a bent manner in relation to the base region abuts the printed circuit board (3), wherein the threaded bush (23) connected to the assembly bracket (4) is arranged in the lug region (22) of the assembly bracket (4).

4. Energy storage arrangement according to claim 3,
**characterised in that**
upstream of the lug region (22) in the direction of the edge of the printed circuit board (3) that abuts the assembly bracket (4), the base region of the assembly bracket (4) is expanded wider than the lug region (22) in the direction of the edge of the printed circuit board (3), wherein, downstream of the lug region (22) in the direction of the edge of the printed circuit board (3), the base region of the assembly bracket (4) is expanded wider than the lug region (22) in the direction of the edge of the printed circuit board (3).

5. Energy storage arrangement according to any of the preceding claims, **characterised in that**
- the energy storage device (43) has a second busbar (10) that conducts a second, in particular lower, potential,
- a second assembly bracket,
- a second connection sheet,
- a second controllable semiconductor switch that is fitted on the printed circuit board (3),
wherein the printed circuit board (3) is fitted with a second connection element,
wherein the printed circuit board (3) is connected, in particular screw-connected, to the second assembly bracket,
wherein the first assembly bracket (4) is spaced apart from the second assembly bracket,
wherein the second assembly bracket is connected to the housing part, in particular in an integrally bonded manner,
in particular wherein the second connection element is electrically connected, in particular press-fitted, to a second conducting track of the printed circuit board (3),
wherein the second busbar (10) is connected, in particular screw-connected, to the second connection element,
wherein a terminal of the second semiconductor switch is electrically connected to the second connection element by means of a fuse (41) and/or a shunt resistor, and another terminal of the second semiconductor switch is connected to the second assembly bracket and the second connection sheet in an electrically and thermally conductive manner in order to carry away thermal losses of the second semiconductor switch, wherein the first assembly bracket (4) and the first connection sheet (6) are interconnected in an electrically and thermally conductive manner.

6. Energy storage arrangement according to any of the preceding claims,
**characterised in that**
the first and/or the second assembly bracket (4) is/are formed as a sheet metal part, in particular as a punched and bent part.

7. Energy storage arrangement according to any of the preceding claims,
**characterised in that**
the housing part, the first assembly bracket and/or the second assembly bracket (4) is/are formed as a composite part, in particular wherein the two assembly brackets (4) are overmoulded at least in part with plastics material of the housing part.

8. Energy storage arrangement according to claim 5,
**characterised in that**
the controllable semiconductor switches (21, T1, T2) are each configured as a parallel circuit of a plurality of semiconductor switches,
in particular wherein each of the parallel circuits has a first and a second semiconductor switch, wherein, in each of the parallel circuits, the second semiconductor switch is placed directly on the opposite printed circuit board side to the first semiconductor switch (21, T1) and said second semiconductor switch is connected to said first semiconductor switch (21, T1) in a heat-conducting manner by means of one or more vias.

9. Energy storage arrangement according to any of the preceding claims,
**characterised in that**
the housing part is made of plastics material.

10. Energy storage arrangement according to any of the preceding claims,
**characterised in that**
the first connection sheet (6) has a protruding first pin
and/or **in that**
the second connection sheet has a protruding second pin.

11. Energy storage arrangement according to any of claims 5 or 8,
**characterised in that**
the energy storage device (43) is connected in series with the first semiconductor switch (21, T1), the second semiconductor switch, a fuse (41) and/or a shunt resistor (42).

12. Vehicle comprising an energy storage arrangement according to any of the preceding claims,
**characterised in that**
the vehicle is a mode of transport in an intralogistics facility,
in particular wherein the mode of transport is an automatically driven vehicle or a driverless transportation system or a mobile assistance system.

## Revendications

1. Agencement de stockage d'énergie
comprenant
- un accumulateur d'énergie (43) muni d'une première barrette conductrice (2) guidant un premier potentiel, notamment supérieur,
- une partie formant boîtier, notamment une partie inférieure (31),
- une plaquette imprimée (3),
- une première cornière de montage (4),
- une première tôle de rattachement (6),
- un premier interrupteur semi-conducteur commandable (21, T1), implanté sur ladite plaquette imprimée (3),
**caractérisé par le fait que**
la plaquette imprimée (3) est reliée à la première cornière de montage (4), notamment reliée par vissage,
ladite première cornière de montage (4) est reliée à la partie formant boîtier, en particulier matériellement, notamment en tant que pièce composite,
la plaquette imprimée (3) est dotée d'un premier élément de raccordement (9),
sachant, en particulier, que ledit premier élément de raccordement (9) est connecté électriquement à une première piste conductrice de ladite plaquette imprimée (3), notamment relié par emboîtement à force,
la première barrette conductrice (2) étant reliée audit premier élément de raccordement (9), notamment reliée par vissage,
sachant qu'une connexion du premier interrupteur semi-conducteur (21, T1) est raccordée électriquement audit premier élément de raccordement (9), et qu'une autre connexion dudit premier interrupteur semi-conducteur (21, T1) est en liaison électriquement et thermiquement conductrice avec la première cornière de montage (4) et avec la première tôle de rattachement (6), en vue de la dissipation de chaleur perdue dudit premier interrupteur semi-conducteur (21, T1), ladite première cornière de montage (4) et ladite première tôle de rattachement (6) étant en liaison mutuelle électriquement et thermiquement conductrice.

2. Agencement de stockage d'énergie selon la revendication 1,
**caractérisé par le fait que**
la cornière de montage (4) est reliée à une douille taraudée (23) emboîtée à force dans une première connexion transversale de la plaquette imprimée (3),
la première tôle de rattachement (6) étant reliée à une autre douille taraudée (23) emboîtée à force dans une seconde connexion transversale de ladite plaquette imprimée (3),
une piste conductrice de ladite plaquette imprimée (3) raccordant électriquement la première connexion transversale à la seconde, ainsi qu'à l'autre connexion de l'interrupteur semi-conducteur (21, T1),
sachant notamment que des pistes conductrices de la plaquette imprimée (3), disposées dans différentes couches de ladite plaquette imprimée (3) de réalisation multicouches, raccordent électriquement la première connexion transversale à la seconde, ainsi qu'à l'autre connexion dudit interrupteur semi-conducteur (21, T1).

3. Agencement de stockage d'énergie selon la revendication 1 ou 2,
**caractérisé par le fait que**
la plaquette imprimée (3) est en applique contre la cornière de montage (4), et est alignée, une arête de ladite plaquette imprimée (3) étant en applique contre ladite cornière de montage (4), en particulier contre une zone de la surface de base de ladite cornière de montage (4), sachant qu'une zone de bridage (22), de réalisation coudée vers ladite zone de surface de base, est en applique contre ladite plaquette imprimée (3), sachant que la douille taraudée (23), reliée à la cornière de montage (4), est disposée dans ladite zone de bridage (22) de ladite cornière de montage (4).

4. Agencement de stockage d'énergie selon la revendication 3,
**caractérisé par le fait que**,
dans la direction de l'arête de la plaquette imprimée (3) en applique contre la cornière de montage (4), la zone de la surface de base de la cornière de montage (4) s'étend, devant la zone de bridage (22), plus loin que ladite zone de bridage (22) dans la direction de ladite arête de ladite plaquette imprimée (3),
sachant que, dans la direction de l'arête de la plaquette imprimée (3), ladite zone de la surface de base de la cornière de montage (4) s'étend, derrière la zone de bridage (22), plus loin que ladite zone de bridage (22) dans la direction de ladite arête de ladite plaquette imprimée (3).

5. Agencement de stockage d'énergie selon l'une des revendications précédentes,
**caractérisé par le fait que**
- l'accumulateur d'énergie (43) est muni d'une seconde barrette conductrice (10) guidant un second potentiel, notamment inférieur,
- une seconde cornière de montage,
- une seconde tôle de rattachement,
- un second interrupteur semi-conducteur commandable, implanté sur la plaquette imprimée (3),
laquelle plaquette imprimée (3) est dotée d'un second élément de raccordement,
ladite plaquette imprimée (3) étant reliée à la seconde cornière de montage, notamment reliée par vissage,
la première cornière de montage (4) étant située à distance de ladite seconde cornière de montage,
laquelle seconde cornière de montage est reliée à la partie formant boîtier, en particulier matériellement,
sachant, en particulier, que ledit second élément de raccordement est connecté électriquement à une seconde piste conductrice de ladite plaquette imprimée (3), notamment relié par emboîtement à force,
ladite seconde barrette conductrice (10) étant reliée audit second élément de raccordement, notamment reliée par vissage,
sachant qu'une connexion du second interrupteur semi-conducteur est raccordée électriquement audit second élément de raccordement par l'intermédiaire d'un fusible (41) et/ou d'une résistance en dérivation, et qu'une autre connexion dudit second interrupteur semi-conducteur est en liaison électriquement et thermiquement conductrice avec la seconde cornière de montage et avec la seconde tôle de rattachement, en vue de la dissipation de chaleur perdue dudit second interrupteur semi-conducteur, la première cornière de montage (4) et la première tôle de rattachement (6) étant en liaison mutuelle électriquement et thermiquement conductrice.

6. Agencement de stockage d'énergie selon l'une des revendications précédentes,
**caractérisé par le fait que**
les première et/ou seconde cornière(s) de montage (4) est (sont) conçue(s) sous la forme d'une pièce en tôle, notamment en tant que pièce venue de matriçage et de pliage.

7. Agencement de stockage d'énergie selon l'une des revendications précédentes,
**caractérisé par le fait que**
la partie formant boîtier, les première et/ou seconde cornière(s) de montage (4) est (sont) conçue(s) sous la forme d'une pièce composite, sachant notamment que les deux cornières de montage (4) sont au moins partiellement enrobées, par injection, au moyen de la matière plastique de ladite partie formant boîtier.

8. Agencement de stockage d'énergie selon la revendication 5,
**caractérisé par le fait que**
les interrupteurs semi-conducteurs commandables (21, T1, T2) sont réalisés, à chaque fois, en tant que branchement en parallèle de plusieurs interrupteurs semi-conducteurs,
sachant, en particulier, que chacun des branchements en parallèle est constitué, à chaque fois, de premier et second interrupteurs semi-conducteurs, auquel cas, dans chacun desdits branchements en parallèle, le second interrupteur semi-conducteur considéré est directement mis en place du côté de la plaquette imprimée tourné à l'opposé du premier interrupteur semi-conducteur (21, T1) respectif, et est en liaison thermiquement conductrice, avec ledit premier interrupteur semi-conducteur (21, T1) respectif, au moyen d'une ou plusieurs connexions(s) transversales(s) de ce second interrupteur semi-conducteur considéré.

9. Agencement de stockage d'énergie selon l'une des revendications précédentes,
**caractérisé par le fait que**
la partie formant boîtier est fabriquée en matière plastique.

10. Agencement de stockage d'énergie selon l'une des revendications précédentes,
**caractérisé par le fait que**
la première tôle de rattachement (6) présente une première broche en saillie ;
et/ou **par le fait que**
la seconde tôle de rattachement présente une seconde broche en saillie.

11. Agencement de stockage d'énergie selon l'une des revendications 5 ou 8,
**caractérisé par le fait que**
l'accumulateur d'énergie (43) est branché en série avec le premier interrupteur semi-conducteur (21, T1), le second interrupteur semi-conducteur, avec un fusible (41) et/ou avec une résistance en dérivation (42).

12. Véhicule équipé d'un agencement de stockage d'énergie conforme à l'une des revendications précédentes,
**caractérisé par le fait que**
ledit véhicule est un moyen de transport d'une installation intralogistique,
sachant notamment que ledit moyen de transport est un véhicule à guidage automatique ou un système de transport sans conducteur, ou bien un système mobile d'assistance.
